Europäisches Patentamt

European Patent Office

Office européen des brevets

(19)

(11) Numéro de publication : **0 014 149**
**B1**

(12)                    **FASCICULE DE BREVET EUROPÉEN**

(45) Date de publication du fascicule du brevet :
06.05.87

(51) Int. Cl.⁴ : **G 05 F   3/20**, **H 01 L  27/08**,
**H 01 L  29/10**

(21) Numéro de dépôt : 80400098.2

(22) Date de dépôt : 22.01.80

(54) Générateur de tension de référence et circuit de mesure de la tension de seuil de transistor MOS, applicable à ce générateur de tension de référence.

(30) Priorité : 26.01.79 FR 7902052

(43) Date de publication de la demande :
06.08.80 Bulletin 80/16

(45) Mention de la délivrance du brevet :
06.05.87 Bulletin 87/19

(84) Etats contractants désignés :
**DE GB IT NL**

(56) Documents cités :
**US-A- 3 823 332**
**US-A- 3 975 648**
**US-A- 4 096 430**
**SOLID STATE ELECTRONICS, vol. 19, no. 1, 1976, Oxford, GB. K. K. KROELL et al.: "Threshold voltage of narrow channel field effect transistors", pages 77-81**

(73) Titulaire : **COMMISSARIAT A L'ENERGIE ATOMIQUE Etablissement de Caractère Scientifique Technique et Industriel**
**B.P. 510**
**F-75752 Paris Cedex 15 (FR)**

(72) Inventeur : **Audaire, Luc**
**La Cure Saint Cassien**
**F-38500 Voiron (FR)**
Inventeur : **Baylac, Bernard**
**70, Hameau du Château**
**F-38360 Sassenage (FR)**
Inventeur : **Merckel, Gérard**
**43, Hameau du Château**
**F-38360 Sassenage (FR)**

(74) Mandataire : **Mongrédien, André et al**
**c/o BREVATOME 25, rue de Ponthieu**
**F-75008 Paris (FR)**

# 0 014 149

## Description

La présente invention concerne un générateur de tension de référence.

Ce générateur est destiné à l'alimentation des circuits intégrés à grande échelle où sont rassemblés un grand nombre de composants. Ce générateur peut être utilisé, par exemple, comme circuit de référence de tension dans des convertisseurs numérique-analogique ou analogique-numérique pour lesquels la stabilité de la tension conditionne la qualité de la conversion. L'intégration du générateur de référence sur la puce constituant le convertisseur réduit le coût de celui-ci tout en accroissant sa fiabilité.

On connaît un générateur de tension de référence, comprenant une diode polarisée en inverse, commandant la grille d'un transistor de grande dimension polarisé dans la zone de fonctionnement dite de « faible inversion », à caractéristique exponentielle. Ce type de générateur a pour inconvénient de présenter des impédances de fonctionnement très élevées ; les courants qu'il délivre sont très faibles, même pour des tensions importantes, sa stabilité est médiocre et il est très sensible aux champs électromagnétiques environnants.

Un autre générateur connu comprend deux transistors MOS de grande géométrie, l'un de type enrichi, l'autre de type appauvri ou déplété, réalisés par implantation ionique, par exemple, et associés à des moyens qui permettent de mesurer la différence des tensions de seuil des transistors. Pour ce générateur, le principal inconvénient réside dans le fait que la tension de seuil n'est pas technologiquement reproductible. La référence de tension doit donc être ajustée, après fabrication. Par ailleurs, les moyens de mesure de différence de tensions de seuil sont en général des amplificateurs différentiels sensibles aux incertitudes technologiques de tensions de seuil. Un générateur de ce type est décrit dans le brevet US-A-3 823 332.

Dans la technique des circuits intégrés de type MIS (métal-isolant-semiconducteur), la tension de référence est en général fournie par des ponts diviseurs potentiométriques entre deux tensions d'alimentation. Ces ponts diviseurs sont constitués par des chaînes de transistors MOS qui permettent de compenser des faibles variations de tensions d'alimentation, des dispersions des tensions de seuil inhérentes à la fabrication des circuits, des variations de tension de seuil liées aux variations de températures de fonctionnement du circuit et enfin, des variations de tensions de seuil liées aux vieillissement de la structure du circuit.

Cependant, ces ponts diviseurs à transistors MOS ne peuvent agir simultanément sur tous ces paramètres et ils ne permettent des compensations que pour de faibles variations de ces paramètres.

La présente invention a pour but de remédier à ces inconvénients et notamment de réaliser un générateur de référence, dont l'impédance de fonctionnement est faible, peu sensible à l'environnement électro-magnétique, et apte à délivrer une tension de référence sans qu'il soit nécessaire d'effectuer des réglages après fabrication. Enfin, l'invention a pour but de réaliser un générateur présentant une très grande stabilité en fonction de la température et des différents paramètres de fonctionnement des circuits.

L'invention a pour objet un générateur de tension de référence comprenant deux transistors $T'$ et $T'_2$ de type MOS, réalisés sur le même substrat, caractérisé en ce que les canaux de ces transistors ayant pour longueurs respectives $L_1$ et $L_2$ et pour largeurs respectives $Z_1$ et $Z_2$, l'un des transistors $T'_2$ présente un canal dont une dimension et une seule est du même ordre de grandeur que la dimension correspondante de l'extension, par rapport à la source $(S'_2)$ et au drain $(D'_2)$ de ce transistor, de la zone de charge d'espace apparaissant autour de cette source et de ce drain lorsque le transistor fonctionne, l'autre dimension étant grande par rapport à la dimension correspondante de ladite extension de zone de charge d'espace, l'autre transistor $T'_1$ présentant un canal dont les deux dimensions sont grandes vis-à-vis de la dimension de l'extension de zone de charge d'espace correspondante, et en ce qu'il comprend des moyens pour fixer la tension commune (VBS) source-substrat des transistors $T'_1$ et $T'_2$ dont les sources $(S_2, S'_2)$ sont réunies à un point commun (S), des moyens pour effectuer la différence des tensions de seuils des transistors $T'_1$ et $T'_2$ par mesure de la différence des tensions respectives grille-source des transistors $T'_1$ et $T'_2$, ces moyens comprenant un condensateur (C') dont les deux bornes sont reliées respectivement à un premier point (D') qui est commun à la grille $(T'_2)$ et au drain $(D'_2)$ du transistor $T'_2$ et à un second point (D") qui est commun à la grille $(T'_1)$ et au drain $(D'_1)$ du transistor $T'_1$ par l'intermédiaire de deux interrupteurs $(I_3, I'_3)$ de commande de charge et de décharge, les premier et second points (D', D") communs étant réunis à une source de tension continue $(V'_1)$, respectivement par l'intermédiaire de deux interrupteurs $(I'_1$ et $I"_1)$ de mise sous tension, de sorte que les deux interrupteurs $(I_3, I'_3)$ de charge et de décharge et les deux interrupteurs $(I'_1$ et $I"_1)$ de mise sous tension étant fermés, chacune des armatures du condensateur (C') se charge au potentiel de la source $(V'_1)$, et de sorte que les interrupteurs $(I'_1$ et $I"_1)$ de mise sous tension étant ouverts et les interrupteurs $(I_3, I'_3)$ de commande de charge et de décharge étant fermés, les armatures du condensateur se déchargent dans les transistors $T'_2$ et $T'_1$, jusqu'à ce que la différence de potentiel disponible aux bornes de ce condensateur (C') égale la différence des tensions de seuil des transistors $T'_1$ et $T'_2$, la différence des tensions de seuil des transistors $T'_2$ et $T'_1$ étant disponible aux bornes du condensateur (C') respectivement par l'intermédiaire de deux interrupteurs de sortie $(I_2, I'_2)$ qui sont fermés après ouverture des interrupteurs $(I_3, I'_3)$ de commande de charge et de décharge, lorsque la différence de potentiel aux bornes du condensateur (C')

2

égale la différence des tensions de seuil des transistors $T'_2$ et $T'_1$.

Selon une autre caractéristique de l'invention, le générateur de tension de référence comprend des moyens pour fixer la tension substrat-source des transistors $T'_1$ et $T'_2$ dont les sources sont réunies à un point commun.

Selon une autre caractéristique, les moyens pour effectuer la différence de tensions de seuil des transistors $T'_1$ et $T'_2$ comprennent des moyens pour mesurer la différence des tensions respectives grille-source des transistors $T'_1$ et $T'_2$.

Selon une caractéristique avantageuse de l'invention, les moyens pour mesurer la différence des tensions respectives grille-source des transistors $T'_1$ et $T'_2$ comprennent un condensateur dont les deux bornes sont reliées respectivement à un premier point qui est commun à la grille et au drain du transistor $T'_2$ et à un second point qui est commun à la grille et au drain du transistor $T'_1$, par l'intermédiaire de deux interrupteurs de commande de charge et de décharge, les premier et second points communs étant réunis à une source de tension continue, respectivement par l'intermédiaire de deux interrupteurs de mise sous tension, de sorte que les deux interrupteurs de charge et de décharge et les deux interrupteurs de mise sous tension étant fermés, chacune des armatures du condensateur se charge au potentiel de la source, puis les interrupteurs de mise sous tension étant ouverts et les interrupteurs de commande de charge et de décharge étant fermés, les armatures du condensateur se déchargent dans les transistors $T'_1$ et $T'_2$ jusqu'à ce que la différence de potentiel disponible aux bornes de ce condensateur égale la différence de seuil des transistors $T'_1$ et $T'_2$.

Selon une autre caractéristique du générateur de l'invention, la différence des tensions de seuil des transistors $T'_2$ et $T'_1$ est disponible aux bornes du condensateur respectivement par l'intermédiaire de deux interrupteurs de sortie qui sont fermés après ouverture des interrupteurs de commande de charge et de décharge, lorsque la différence de potentiel aux bornes du condensateur égale la différence des tensions de seuil des transistors $T'_1$ et $T'_2$.

Selon une caractéristique avantageuse, les interrupteurs de charge et de décharge, les interrupteurs de mise sous tension et les interrupteurs de sortie sont des transistors MOS dont les grilles sont reliées à des moyens de commande pour rendre conducteurs les transistors de commande de charge et de décharge et les interrupteurs de mise sous tension, pendant un temps suffisant pour charger les armatures du condensateur au potentiel de la source, puis pour bloquer les transistors de mise sous tension pour que les armatures du condensateur se déchargent dans les transistors $T'_2$ et $T'_1$ jusqu'à ce que la différence de potentiel à ses bornes égale la différence des tensions de seuil des transistors $T'_2$ et $T'_1$, puis pour rendre conducteurs les transistors de sortie lorsque cette différence des tensions de seuil est atteinte, cette tension étant disponible entre les sources de ces transistors de sortie dont les drains sont reliés aux bornes du condensateur, les drains des transistors $T'_2$ et $T'_1$ étant reliés respectivement aux drains des transistors de charge et de décharge dont les sources sont reliées à ladite source de tension continue.

D'autres caractéristiques et avantages de l'invention ressortiront encore de la description qui va suivre, donnée à titre purement illustratif, en référence aux dessins annexés, sur lesquels :

la figure 1   représente schématiquement trois transistors $t_1$, $t_2$, $t_3$ de type MOS, de différentes dimensions, réalisés sur le même substrat ;

la figure 2   représente de manière plus détaillée, l'un des transistors de la fig. 1 ;

la figure 2a   représente ce transistor en coupe longitudinale, dans le sens de la longueur L du canal ;

la figure 2b   représente ce transistor en coupe latérale dans le sens de la largeur Z du canal ;

la figure 3   est un diagramme qui représente les différences de tensions de seuil entre deux des transistors de la fig. 1, lorsque la tension source-substrat appliquée à ces transistors varie, et pour différentes dimensions de ces transistors ;

la figure 4a   représente schématiquement un circuit de mesure de tension de seuil d'un transistor MOS ;

la figure 4b   est un diagramme représentant un signal de commande intervenant dans le circuit de la fig. 4a ;

la figure 5   représente schématiquement un générateur de tension de référence, conforme à l'invention.

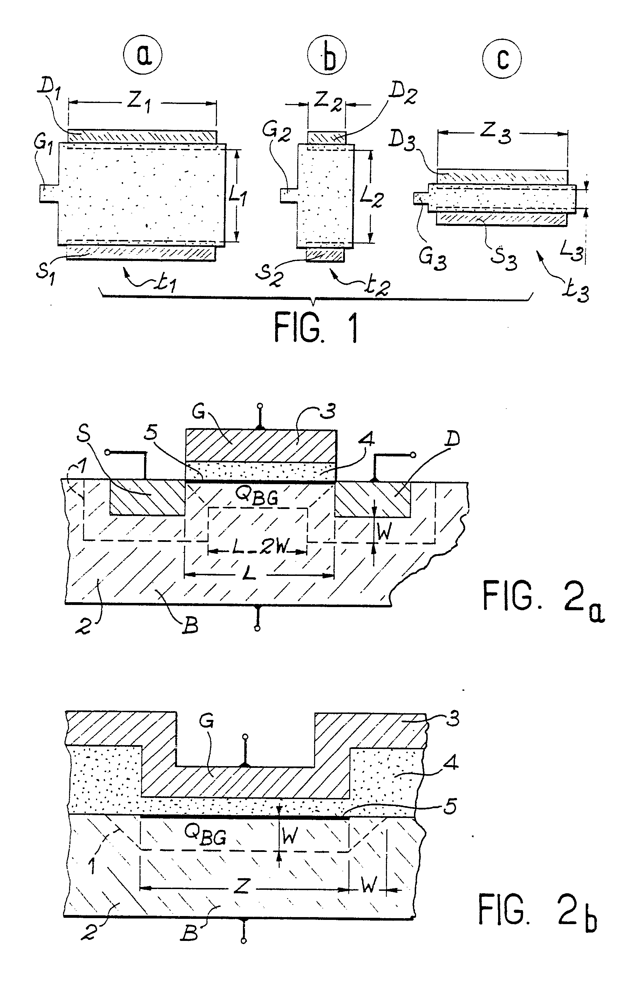

En référence à la fig. 1, on a représenté trois transistors $t_1$, $t_2$, $t_3$ de type MOS réalisés sur le même substrat, mais représentés séparément sur la figure. $G_1$, $G_2$, $G_3$ désignent les grilles respectives de ces transistors tandis que $D_1$, $D_2$, $D_3$ désignent respectivement les drains et que $S_1$, $S_2$, $S_3$ désignent respectivement les sources. $L_1$, $L_2$, $L_3$ sont les longueurs des canaux des transistors $t_1$, $t_2$, $t_3$ tandis que $Z_1$, $Z_2$, $Z_3$ désignent respectivement les largeurs de ces canaux. Il est bien évident que les transistors représentés sur cette figure sont des transistors MOS, soit de type « à canal P », soit de type « à canal N ». On supposera par exemple que les dimensions du transistor $t_1$ sont telles que $Z_1$ et $L_1$ sont supérieures à 30 $\mu$. De la même manière, pour $t_2$, on suppose que $Z_2$ est inférieure à 5 $\mu$ et que $L_2$ est supérieure à 30 $\mu$. Enfin, pour le transistor $t_3$, $Z_3$ est supérieure à 30 $\mu$ et $L_3$ est inférieure à 5 $\mu$.

En référence à la fig. 2a, on a représenté de manière plus détaillée l'un des transistors de la fig. 1, en coupe schématique dans le sens de la longueur L du canal, de manière à faire apparaître l'influence de la longueur du canal sur la tension de seuil $V_t$ du transistor. Sur cette figure S, G, D, B désignent respectivement la source, la grille, le drain et le substrat du transistor MOS représenté. L'extension de la

3

zone de charge d'espace, d'épaisseur W, est délimitée par la ligne en pointillés 1, dont la position dépend de la valeur de la tension $V_{BS}$ appliquée entre le substrat B et la source S du transistor. Le substrat B peut être de type P ou de type N, et la neutralité électrique est conservée dans le volume, loin de la surface. La grille G est constituée de manière connue par une couche 3 d'aluminium, déposée sur une couche isolante 4. Le canal d'inversion 5 est formé dès que la tension appliquée entre la grille et la source est supérieure à la tension de seuil $V_t$ du transistor. La tension de seuil est donnée par la relation connue :

$$V_T = V_{F_B} + 2\phi_F + (Q_{B_G}/Co \cdot ZL)$$

Dans cette relation, $V_{F_B}$ désigne la tension de bandes plates, $\phi_F$ désigne le potentiel de Fermi du substrat, $Q_{B_G}$ désigne la charge d'espace contrôlée pour l'électrode de grille, Cox désigne la capacité de cette électrode par unité de surface, Z et L expriment respectivement la largeur et la longueur du canal du transistor.

La charge $Q_{B_G}$ du substrat est proportionnelle au dopage dudit substrat et au volume de la charge d'espace contrôlée par l'électrode de grille.

Pour un transistor de grandes dimensions, ce volume est égal au produit WZL, où W désigne l'épaisseur de la zone de charge d'espace. Dans ce cas, la tension de seuil est indépendante des dimensions L et Z du transistor.

Pour un transistor de faible longueur et de grande largeur du canal, le volume de la charge d'espace est égal à WZL (1 — (W/L)). Il en résulte que sa tension de seuil est plus faible que celle d'un transistor de grandes dimensions. Cet effet est amplifié par une augmentation de la polarisation entre la source et le substrat qui produit une augmentation de l'extension W de la charge d'espace.

En référence à la fig. 2b, on a représenté la coupe, dans le sens latéral, d'un transistor de faible largeur de canal. Dans ce cas, en admettant que la longueur du canal est grande, le volume de la charge d'espace est égal à WZL (1 + (W/Z)). Il en résulte que la tension de seuil du transistor est plus grande que celle d'un transistor de grandes dimensions. Cet effet est également amplifié si la polarisation entre la source et le substrat est augmentée.

Les effets géométriques sur la tension de seuil deviennent négligeables lorsque les dimensions L et Z du transistor sont grandes devant l'extension W de la zone de charge d'espace, c'est-à-dire pour L et Z > 30 μ.

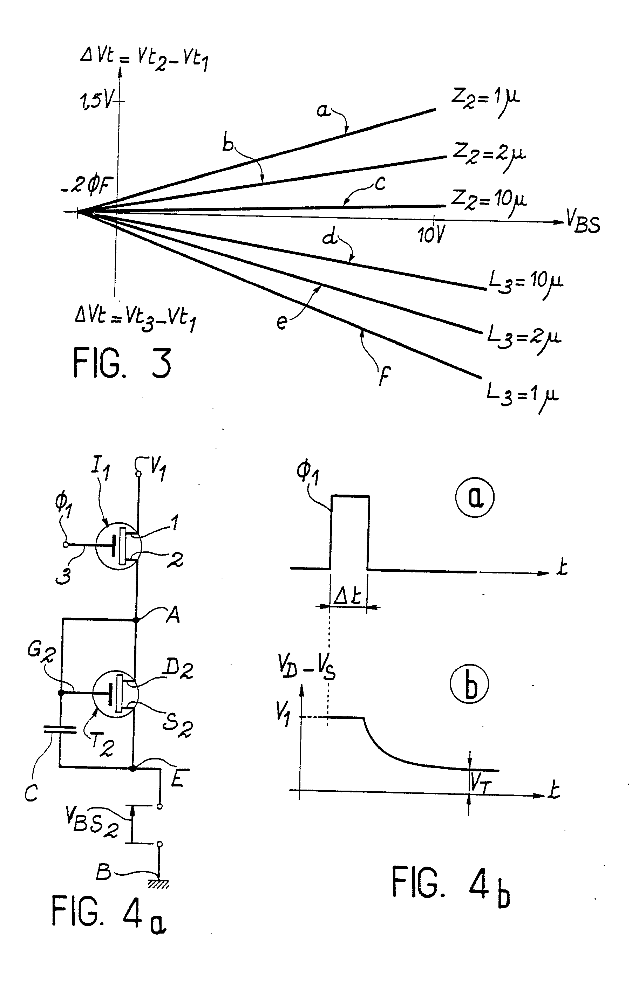

La fig. 3 est un diagramme représentant les différences de tension de seuil de deux transistors de la fig. 1, lorsque la tension substrat-source $V_{BS}$ varie et que ces transistors ont des dimensions différentes. Sur ce diagramme, on a représenté la tension $V_{BS}$ en abscisse, tandis qu'en ordonnée, on a représenté la différence des tensions de seuil $\Delta V_t = V_{t_2} — V_{t_1}$, entre les tensions de seuil des transistors $t_2$ et $t_1$, ou la différence des tensions de seuil $\Delta V_{t_3} — V_{t_1}$, entre les tensions de seuil des transistors $t_3$ et $t_1$. D'une manière générale, cette différence de tension de seuil $\Delta V_t$ est exprimée par la relation approchée :

$$\Delta V_t = (V_{BS} — 2 \phi_F) ((\alpha_1/Z) — (\alpha_2/L)).$$

Dans cette relation, $\alpha_1$ et $\alpha_2$ désignent des coefficients de proportionnalité, Z et L désignent la largeur et la longueur du canal du transistor MOS considéré, $V_{BS}$ désigne la tension substrat-source appliquée à ce transistor, et $\phi_F$ exprime la différence de potentiel de Fermi entre le substrat et le potentiel intrinsèque de ce substrat. Sur ce diagramme, la tension de seuil $V_{t_1}$ du transistor $t_1$ a été prise comme référence. Les courbes a, b, c, représentent respectivement les différences de tensions de seuil des transistors $t_2$ et $t_1$ lorsque la largeur $Z_2$ du transistor $t_2$ prend respectivement les valeurs 1 μ, 2 μ, 10 μ, la longueur $L_2$ du canal de ce transistor étant supérieure à 30 μ. De la même manière, les courbes d, e, f, représentent les différences de tensions de seuil des transistors $t_3$ et $t_1$ en fonction de la tension substrat-source $V_{BS}$, lorsque la longueur $L_3$ du canal du transistor $t_3$ prend respectivement les valeurs 10 μ, 2 μ, 1 μ, et que la largeur $Z_3$ du canal de ce transistor est supérieure à 30 μ. On a bien entendu supposé que le transistor $t_1$ est un transistor de grande dimension pour lequel la longueur $L_1$ et la largeur $Z_1$ du canal sont supérieures à 30 μ. Il est bien évident, compte tenu de la relation mentionnée plus haut et qui exprime la différence des tensions de seuil entre les transistors, que les courbes représentées sur ce diagramme sont des droites passant par un point commun, d'abscisse $— 2 \phi_F$.

Il résulte de l'observation de ce diagramme que la différence de tension est linéaire en fonction de $Z^{-1}$ ou $L^{-1}$, Z désignant ici la largeur $Z_2$ du transistor $t_2$ et L désignant la longueur $L_3$ du canal du transistor $t_3$. Dans la technique des circuits intégrés sur substrat, ces paramètres géométriques peuvent être définis avec une très grande précision. La différence de tensions de seuil entre le transistor de référence et le transistor considéré, est linéaire en fonction de la tension substrat-source $V_{BS}$. Cette différence est pratiquement indépendante de la température, puisque le seul terme de la relation mentionnée plus haut, qui fait intervenir cette température, est le terme $2 \phi_F$ ; on peut considérer que la variation de ce terme avec la température est négligeable.

En référence à la fig. 4a on a représenté schématiquement un circuit de mesure de tension de seuil d'un transistor $T_2$, de type MOS. Ce circuit comprend un condensateur C dont une borne est reliée à la source $S_2$ du transistor et dont une autre borne est reliée à un point A commun, au drain $D_2$ du transistor $T_2$ et à la grille $G_2$ de ce transistor. Un interrupteur $I_1$ permet de commander la charge et la décharge du condensateur C ; cet interrupteur est relié d'une part au point commun A et, d'autre part, à une source de tension continue $V_1$ ; il est constitué par un transistor MOS dont le drain, la source, et la grille sont respectivement référencés 1, 2, 3. La source $S_2$ du transistor MOS $T_2$ est reliée à des moyens de réglage non représentés qui permettent de fixer la tension $V_{BS_2}$ entre le substrat B de ce transistor et sa source $S_2$.

On comprendra mieux le fonctionnement de ce circuit à l'aide des diagrammes A et B de la fig. 4b. On suppose que le transistor $T_2$ est, pour l'une de ses dimensions, un transistor de petite géométrie ; la longueur de son canal par exemple, est inférieure à 5 $\mu$. Lorsque l'interrupteur $I_1$ est fermé, c'est-à-dire lorsqu'un signal de commande $\phi_1$, de durée $\Delta t$, est appliqué à la grille 3 du transistor de commande de charge et de décharge $I_1$, le condensateur C se charge au potentiel $V_1$ de la source de tension continue. Après le temps $\Delta t$, l'interrupteur $I_1$ est ouvert, ce qui correspond au blocage du transistor $I_1$, le condensateur C se décharge dans le transistor $T_2$ jusqu'à ce que la tension à ses bornes soit égale à la tension seuil $V_{T_2}$ du transistor $T_2$. La grille et le drain du transistor $T_2$ sont reliés et il en résulte que la tension aux bornes du condensateur C commande le courant de décharge. Ce courant s'annule lorsque la tension $V_A - V_E$, c'est-à-dire la tension entre le drain $D_2$ du transistor $T_2$ et la source $S_2$ de ce transistor, atteint la tension de seuil $V_{T_2}$ du transistor $T_2$. La tension $V_{D_2} - V_{S_2}$, entre le drain et la source du transistor $T_2$ est alors égale à la tension de seuil $V_{T_2}$ du transistor $T_2$. Cette tension de seuil est commandée par la tension $V_{BS_2}$ appliquée au point commun E à une électrode du condensateur C et à la source $S_2$ du transistor $T_2$. De manière générale, la tension de seuil $V_T$ peut être mesurée par la tension appliquée entre le substrat et la source de ce transistor après mise en œuvre du circuit de la fig. 4a. Le transistor $T_2$ de petite géométrie, le transistor MOS $I_1$, ainsi que le condensateur C peuvent être réalisés sous forme de circuit intégré sur substrat semiconducteur. Comme on le verra par la suite, ce circuit de mesure est applicable au générateur de tension de référence, conforme à l'invention.

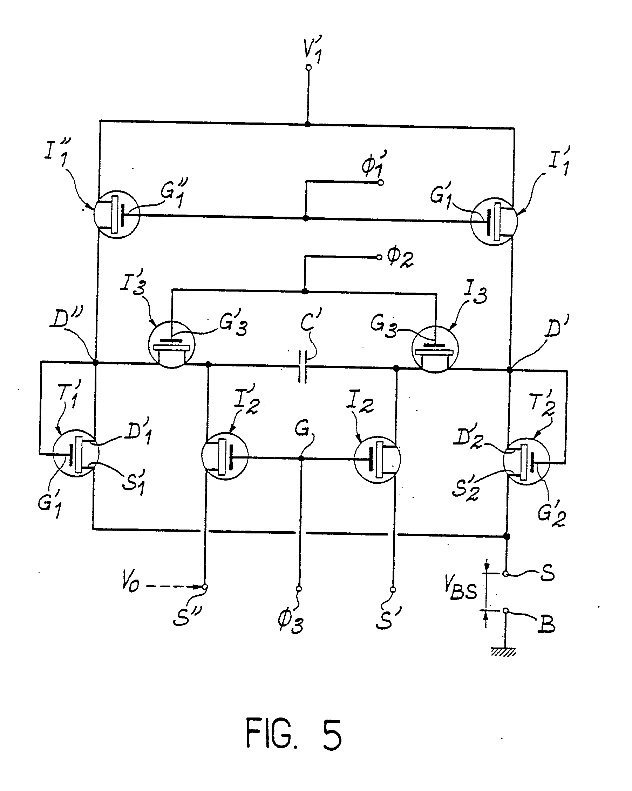

En référence à la fig. 5, on a représenté schématiquement un générateur de tension de référence, qui comprend deux transistors $T'_1$ et $T'_2$ de type MOS, réalisés sur le même substrat B. L'un des transistors $T'_2$ par exemple, est comparable au transistor $T_2$ de la fig. 4a, de petite géométrie ; ce transistor présente un canal dont une dimension et une seule est du même ordre de grandeur que la dimension correspondante de l'extension, par rapport à la source $S'_2$ et au drain $D'_2$ de ce transistor, de la zone de charge d'espace apparaissant autour de cette source et de ce drain, lorsque le transistor fonctionne ; l'autre dimension est grande par rapport à la dimension correspondante de cette extension de zone de charge d'espace ; c'est ainsi, par exemple, que le transistor $T'_2$ présente une longueur $L_2$ de canal inférieure à 5 $\mu$ : le transistor $T'_1$ est un transistor de grande géométrie et présente un canal dont les deux dimensions sont grandes vis-à-vis des dimensions correspondantes de l'extension, par rapport à la source $S'_1$ et au drain $D'_1$ de ce transistor, de la zone de charge d'espace apparaissant autour de cette source et de ce drain lorsque le transistor fonctionne. C'est ainsi, par exemple, que la longueur $L_1$ du canal du transistor $T'_1$ est supérieure à 30 $\mu$. Comme on le verra par la suite, le générateur de référence conforme à l'invention comprend également des moyens qui permettent d'effectuer la différence des tensions de seuil des transistors $T'_1$ et $T'_2$ ; cette différence est représentative de la tension de référence. Le générateur comprend également des moyens, non représentés, qui permettent de fixer la tension commune $V_{BS}$ entre le substrat sur lequel sont formés les transistors $T'_1$ et $T'_2$, les sources $S'_1$ et $S'_2$ de ces transistors étant réunies à un point commun S.

Les moyens qui permettent d'effectuer la différence des tensions de seuil des transistors $T'_1$ et $T'_2$ comprennent des moyens pour mesurer la différence des tensions respectives grille-source des transistors $T'_1$ et $T'_2$. Ces moyens comprennent un condensateur C' dont les deux bornes sont reliées respectivement à un premier point D' qui est commun à la grille $G'_2$ et au drain $D'_2$ du transistor $T'_2$ et à un second point D" qui est commun à la grille $G'_1$ et au drain $D'_1$ du transistor $T'_1$ par l'intermédiaire de deux interrupteurs $I_3$, $I'_3$ qui permettent de commander la charge et la décharge du condensateur C' ; ces interrupteurs $I_3$ et $I'_3$ sont constitués par des transistors MOS identiques ; les grilles $G_3$ et $G'_3$ de ces transistors sont réunies entre elles et peuvent recevoir des signaux de commande de commutation $\phi_2$ ; le drain et la source de chacun des transistors $I_3$ et $I'_3$ sont respectivement reliés aux bornes du condensateur C' et aux points communs D', D", aux grilles et aux drains des transistors $T'_1$ et $T'_2$. Les premier et second points communs D' et D" sont réunis à une source de tension continue $V'_1$ respectivement par l'intermédiaire de deux interrupteurs $I'_1$ et $I''_1$, de mise sous tension. Ces interrupteurs sont constitués par des transistors MOS identiques, leurs grilles $G'_1$ et $G''_1$ sont reliées entre elles et peuvent être connectées à des moyens de commande non représentés, de manière à recevoir des signaux de commutation $\phi'_1$ permettant de faire passer ces transistors, soit à l'état bloqué, soit à l'état conducteur. Les drains de ces transistors sont reliés à la source de tension $V'_1$ tandis que leurs sources sont respectivement reliées au premier et au second points communs D' et D". Comme on le verra plus loin en détail, la différence des tensions de seuil des transistors $T'_1$ et $T'_2$ est obtenue aux bornes du condensateur C'. Le générateur de tension de référence comprend aussi deux interrupteurs de sortie $I_2$ et $I'_2$ qui permettent de recueillir cette tension de référence aux bornes du condensateur C'. Ces interrupteurs de sortie sont constitués par des transistors MOS, dont les états bloqués et conducteurs sont commandés par des signaux de commutation $\phi_3$ appliqués à un point commun G de ce circuit ainsi que le condensateur C' et sont réalisés sous forme de circuit intégré sur substrat.

Le fonctionnement du générateur de tension de référence représenté sur la fig. 5 sera maintenant

5

mieux compris à l'aide des explications qui vont suivre. Ce générateur met en œuvre deux circuits de mesure de tensions de seuil, décrits précédemment, en référence aux fig. 4a et 4b.

Les interrupteurs identiques $I_3$ et $I'_3$ commandés par les signaux de commutation $\phi_2$ permettent d'isoler le condensateur C' des autres parties du générateur. Les interrupteurs $I'_1$ et $I''_1$, commandés par les signaux de commutation $\phi'_1$ permettent de précharger les bornes du condensateur C' à la tension $V'_1$, tandis que les interrupteurs $I_2$ et $I'_2$, commandés par les signaux de commutation $\phi_3$ permettent de mettre le condensateur en relation avec le circuit d'utilisation, auquel doit être fournie la tension de référence, et qui est connectée entre les électrodes S' et S" des transistors constituant les interrupteurs $I_2$ et $I'_2$. Comme on l'a indiqué précédemment, les transistors $T'_2$ et $T'_1$ sont de géométrie choisie pour une différence de tension de seuil $V_{T_2} - V_{T_1}$ donnée. la tension de référence est alors obtenue de manière suivante :

1) Les interrupteurs $I'_1$, $I''_1$, $I_3$, $I'_3$ sont fermés par application de signaux de commutation $\phi'_1$, $\phi'_2$ sur la grille des transistors correspondants. Les interrupteurs $I_2$ et $I'_2$ sont supposés ouverts pendant le temps de fermeture des interrupteurs $I'_1$, $I''_1$, $I_3$, $I'_3$.

En fermant les interrupteurs $I'_1$ et $I''_1$, on réalise un montage parallèle entre la borne au potentiel $V'_1$ et la borne S, la première branche comprenant en série les deux transistors $I'_1$ et $T'_2$ à l'état passant, la seconde branche comprenant les transistors $I''_1$ et $T'_1$ également à l'état passant. Ces transistors ont des caractéristiques et des tensions de seuil différentes et il en résulte que les deux branches sont traversées par des courants différents et que les potentiels des points D' et D" sont différents. Il en résulte que le condensateur C' se charge, grâce à la fermeture des interrupteurs $I'_1$ et $I''_1$, par la différence de potentiel non nulle entre les points D' et D". Lorsque les interrupteurs $I'_1$ et $I''_1$ sont fermés, les transistors $T'_1$ et $T'_2$ sont passants, avec des tensions grille-source supérieures à leur valeur de seuil.

2) Les interrupteurs $I_3$ et $I'_3$ restent fermés, tandis que les interrupteurs $I'_1$, $I''_1$, $I_2$, $I'_2$ sont ouverts, grâce à l'application de signaux de blocage $\phi'_1$, $\phi'_3$ sur les grilles des transistors correspondants. Il en résulte que le condensateur C' se décharge à travers les transistors $T'_2$ et $T'_1$ ; cette décharge s'arrête lorsque la tension $VD' - V_S$ entre la grille et la source du transistor $T'_1$ est égale à la tension de seuil $V_{T'}$ de ce transistor et que la tension $VD'_2 - V_S$ entre la grille et la source du transistor $T'_2$ est égale à la tension de seuil $V_{T'_1}$ de ce transistor. Il en résulte que la différence de potentiel $VD'_1 - VD'_2$ entre les grilles ou les drains des transistors $T'_1$ et $T'_2$ est égale à la différence de tension de seuil $V_{T_1} - V_{T_2}$ des deux transistors $T'_1$ et $T'_2$. Cette différence de tension de seuil est commandée par la tension $V_{BS}$, appliquée entre le substrat B sur lequel sont formés les transistors MOS, et le point commun S des sources $S'_1$ et $S'_2$ des transistors $T'_1$ et $T'_2$. L'ouverture des interrupteurs $I'_1$ et $I''_1$ fait décroître les tensions grille-source des transistors $T'_1$ et $T'_2$ et par conséquent, leur courant grille-source jusqu'à leur blocage respectif qui n'est pas simultané.

La condition nécessaire que doit remplir ce circuit pour pouvoir fonctionner est que la tension grille-source des deux transistors qui est égale à la tension de seuil reste constante pendant un temps suffisamment long pour que le potentiel de chaque électrode du condensateur (C') s'égalise avec celui de la grille du transistor à laquelle cette électrode est reliée par l'un des interrupteurs $I_3$ et $I'_3$.

L'invention permet donc de disposer d'une tension de référence égale à la différence des vraies tensions de seuil des deux transistors $T'_1$ et $T'_2$.

L'interrupteur $I_1$ n'est fermé que pendant un intervalle de temps assez court $\Delta t$, puis est ouvert, ce qui permet après un certain temps d'utiliser la tension de seuil de $T_2$ comme tension de référence, ce qui va apparaître à l'étape suivante.

3) Les interrupteurs $I'_1$, $I''_1$, $I_3$, $I'_3$ sont ensuite ouverts par application de signaux de commande $\phi'_1$, $\phi_2$, sur les transistors correspondants, tandis que les interrupteurs $I_2$, $I'_2$ sont fermés, par application d'un signal de commande $\phi_3$ sur la grille des transistors correspondants. La différence de tension de seuil $V_{T_1} - V_{T_2}$ est alors disponible pour le circuit d'utilisation connecté entre les bornes S' et S" des interrupteurs $I_2$ et $I'_2$. Cette tension reste stable lorsque la température ambiante varie. Le circuit d'utilisation doit impérativement présenter une très haute impédance d'entrée. La différence de potentiel $V_{T_1} - V_{T_2}$, peut être portée à un potentiel arbitraire en reliant l'électrode S" par exemple, à un potentiel de polarisation $V_0$ ; il en résulte que par rapport au substrat B, le point S' présente alors un potentiel égal à $V_0 + V_{T_1} - V_{T_2}$. En particulier, le point S" peut être porté à un potentiel $V_0$ représentant une tension de seuil mesurée par un circuit tel que celui qui a été décrit en référence à la figure 4a ; le point S' peut alors servir à polariser un transistor MOS avec précision.

Si l'on se réfère au montage de la figure 4a, il est également clair que le condensateur (C) est indispensable au circuit de la figure 5 parce que c'est grâce à lui qu'après l'ouverture de l'interrupteur $I_1$ subsiste une tension entre, d'une part, la grille ou le drain, c'est-à-dire le point A et, d'autre part, la source, c'est-à-dire le point E du transistor $T_2$ ; cette tension étant, au moment de l'ouverture de l'interrupteur $I_1$, plus élevée que la tension du seuil du transistor $T_2$, le condensateur (C) va se décharger jusqu'à ce que sa tension soit devenue égale à la tension de seuil du transistor $T_1$.

La différence de potentiel aux bornes du condensateur (C), disponible comme tension de référence, est aussi égale à la tension de seuil du transistor $T_2$. De même que le circuit du transistor $T'_1$ de la figure 5 comprend une capacité supplémentaire équivalente à la capacité (C) de la figure 4a, le circuit du transistor $T'_2$ comprend sa capacité propre équivalente à C.

Les capacités supplémentaires dont il est question sont par exemple les capacités parasites présentes dans un circuit intégré et inhérentes à ce circuit.

L'homme de l'art en est parfaitement averti et sait par ailleurs qu'il est possible de donner à ces capacités une valeur bien déterminée au cours de la fabrication des circuits. Il se sert de cette connaissance pour la conception desdits circuits. On peut se reporter pour plus d'informations aux pages 30 et 31 de l'ouvrage de H. Lilen, intitulé « Principes et applications des circuits intégrés » (1972) où de telles capacités sont appelées « capacités de structure ». La description de l'invention donne une indication dans ce sens puisqu'à la page 9, lignes 31 à 33, elle explique que « le transistor $T_2$ de petite géométrie, le transistor MOS I, ainsi que le condensateur C, peuvent être réalisés sous forme de circuit intégré sur substrat semi-conducteur ».

Le générateur de tension de référence qui vient d'être décrit et qui est réalisé sous forme de circuit intégré, peut être utilisé pour l'alimentation de circuits intégrés très variés et notamment pour l'alimentation de convertisseurs analogique-numérique ou numérique-analogique qui exigent une tension de référence très stable, afin que les résultats des conversions ne soient pas erronés. Ce générateur de tension de référence peut également être utilisé dans les microprocesseurs ainsi que dans tous les systèmes qui peuvent être connectés à ces microprocesseurs ou encore dans les circuits de codage et de décodage de la parole en télécommunication.

## Revendications

1. Générateur de tension de référence comprenant deux transistors $T'_1$ et $T'_2$ de type de MOS, réalisés sur le même substrat, caractérisé en ce que les canaux de ces transistors ayant pour longueurs respectives $L_1$ et $L_2$ et pour largeurs respectives $Z_1$ et $Z_2$, l'un des transistors $T'_2$ présente un canal dont une dimension et une seule est du même ordre de grandeur que la dimension correspondante de l'extension, par rapport à la source ($S'_2$) et au drain ($D'_2$) de ce transistor, de la zone de charge d'espace apparaissant autour de cette source et de ce drain lorsque le transistor fonctionne, l'autre dimension étant grande par rapport à la dimension correspondante de ladite extension de zone de charge d'espace, l'autre transistor $T'_1$ présentant un canal dont les deux dimensions sont grandes vis-à-vis de la dimension de l'extension de zone de charge d'espace correspondante, et en ce qu'il comprend des moyens pour fixer la tension commune (VBS) source-substrat des transistors $T'_1$ et $T'_2$ dont les sources ($S_2$, $S'_2$) sont réunies à un point commun (S), des moyens pour effectuer la différence des tensions de seuils des transistors $T'_1$ et $T'_2$ par mesure de la différence des tensions respectives grille-source des transistors $T'_1$ et $T'_2$, ces moyens comprenant un condensateur (C') dont les deux bornes sont reliées respectivement à un premier point (D') qui est commun à la grille ($T'_2$) et au drain ($D'_2$) du transistor $T'_2$ et à un second point (D") qui est commun à la grille ($T'_1$) et au drain ($D'_1$) du transistor $T'_1$ par l'intermédiaire de deux interrupteurs ($I_3$, $I'_3$) de commande de charge et de décharge, les premier et second points (D', D") communs étant réunis à une source de tension continue ($V'_1$), respectivement par l'intermédiaire de deux interrupteurs ($I'_1$ et $I''_1$) de mise sous tension, de sorte que les deux interrupteurs ($I_3$, $I'_3$) de charge et de décharge et les deux interrupteurs ($I'_1$ et $I''_1$) de mise sous tension étant fermés, chacune des armatures du condensateur (C') se charge au potentiel de la source ($V'_1$), et de sorte que les interrupteurs ($I'_1$ et $I''_1$) de mise sous tension étant ouverte et les interrupteurs ($I_3$, $I'_3$) de commande de charge et de décharge étant fermés, les armatures du condensateur se déchargent dans les transistors $T'_2$ et $T'_1$, jusqu'à ce que la différence de potentiel disponible aux bornes de ce condensateur (C') égale la différence des tensions de seuil des transistors $T'_1$ et $T'_2$, la différence des tensions de seuil des transistors $T'_2$ et $T'_1$ étant disponible aux bornes du condensateur (C') respectivement par l'intermédiaire de deux interrupteurs de sortie ($I_2$, $I'_2$) qui sont fermés après ouverture des interrupteurs ($I_3$, $I'_3$) de commande de charge et de décharge, lorsque la différence de potentiel aux bornes du condensateur (C') égale la différence des tensions de seuil des transistors $T'_2$ et $T'_1$.

2. Générateur de tension de référence selon la revendication 1, caractérisé en ce que les interrupteurs ($I_3$, $I'_3$) de charge et de décharge, les interrupteurs ($I'_1$, $I''_1$) de mise sous tension et les interrupteurs de sortie ($I_2$ et $I'_2$) sont des transistors MOS dont les grilles sont reliées à des moyens de commande ($\phi_3$) pour rendre conducteurs les transistors ($I_3$ et $I'_3$) de commande de charge et de décharge et les transistors de mise sous tension ($I'_1$, $I''_1$), pendant un temps suffisant pour charger les armatures du condensateur (C') au potentiel de la source ($V'_1$), puis pour bloquer les transistors ($I'_1$, $I''_1$) de mise sous tension pour que les armatures du condensateur (C') se déchargent dans les transistors $T_2$ et $T'_1$, jusqu'à ce que la différence de potentiel à ses bornes égale la différence des tensions de seuil des transistors $T'_2$ et $T'_1$, puis pour rendre conducteurs les transistors ($I_2$, $I'_2$) de sortie lorsque cette différence des tensions de seuil est atteinte, cette tension étant disponible entre les sources de ces transistors ($I_2$, $I'_2$) de sortie dont les drains sont reliés aux bornes du condensateur (C'), les drains des transistors $T'_2$ et $T'_1$ étant reliés respectivement aux drains des transistors ($I_3$, $I'_3$) de charge et de décharge dont les sources sont reliées à ladite source de tension continue ($V'_1$).

3. Générateur de tension de référence selon la revendication 2, caractérisé en ce que la source de l'un des transistors de sortie ($I'_2$) est reliée à des moyens pour porter cette source à un potentiel ($V_0$) prédéterminé de polarisation par rapport au potentiel du substrat des transistors $T'_2$ et $T'_1$.

4. Générateur de tension de référence selon la revendication 3, caractérisé en ce que la longueur $L_1$

du canal T'$_1$ est supérieure à 30 μ et que la longueur L$_2$ ou la largeur Z$_2$ du canal de T'$_2$ est inférieure à 5 μ.

5. Générateur de tension de référence selon la revendication 4, caractérisé en ce que le condensateur (C') et les transistors MOS sont réalisés sous forme de circuit intégré sur substrat.

## Claims

1. Reference voltage generator including two MOS transistors T'$_1$ and T'$_2$, produced on the same substrate, characterized in that the channels of these transistors have respective lengths of L$_1$ and L$_2$ and respective widths of Z$_1$ and Z$_2$, one of the transistors T'$_2$ has a channel of which one and only one dimension is in the same order of magnitude as the corresponding dimension of the extension, with respect to the source (S'$_2$) and to the drain (D'$_2$) of this transistor, of the space charge zone appearing around this source and of this drain when the transistor is functionning, the other dimension being large with respect to the corresponding dimension of the said space charge zone extension, the other transistor T'$_1$ having a channel of which both dimensions are large with respect to the dimension of the corresponding space charge zone extension, and in that it includes means of fixing the common source-substrate voltage (VBS) of the transistors T'$_1$ and T'$_2$ whose sources (S$_2$, S'$_2$) are connected to a common point (S), means of producing the difference in threshold voltages of transistors T'$_1$ and T'$_2$ by measuring the difference in the respective grid-source voltages of the transistors T'$_1$ and T'$_2$, these means including a capacitor (C') whose two terminals are respectively connected to a first point (D') which is common to the grid (T'$_2$) and to the drain (D'$_2$) of the transistor T'$_2$ and to a second point (D'') which is common to the grid (T'$_1$) and to the drain (D'$_1$) of the transistor T'$_1$ by means of two switches (I$_3$, I'$_3$) for controlling charging and discharging, the first and second common points (D', D'') being connected to a d.c. voltage source (V'$_1$), by means of two power-on switches (I'$_1$ and I''$_1$) respectively, so that the two charging and discharging switches (I$_3$, I'$_3$) and the two power-on switches (I'$_1$ and I''$_1$) being closed, each of the plates of the capacitor (C') charges to the potential of the source (V'$_1$), and so that the power-on switches (I'$_1$ and I''$_1$) being open and the charge and discharge control switches (I$_3$, I'$_3$) being closed, the plates of the capacitor discharge into the transistors T'$_2$ and T'$_1$, until the potential difference available at the terminals of this capacitor (C') equals the difference in threshold voltages of transistors T'$_1$ and T'$_2$, the difference in threshold voltages of transistors T'$_2$ and T'$_1$ being available at the terminals of the capacitor (C') by means of the two output switches (I$_2$, I'$_2$) respectively which are closed after the opening of the charge and discharge control switches (I$_3$, I'$_3$), when the potential difference at the terminals of the capacitor (C') equals the difference in threshold voltages of the transistors T'$_2$ and T'$_1$.

2. Reference voltage generator according to Claim 1, characterized in that the charge and discharge switches (I$_3$, I'$_3$), the power-on switches (I'$_1$, I''$_1$) and the output switches (I$_2$ and I'$_2$) are MOS transistors whose grids are connected to means of control (φ$_3$) in order to make the charge and discharge control transistors (I$_3$ and I'$_3$) and the power-on transistors (I'$_1$, I''$_1$) conducting, for a time that is sufficient to charge the plates of the capacitor (C') to the potential of the source (V'$_1$), and then to cut off the power-on transistors (I'$_1$, I''$_1$) so that the plates of the capacitor (C') discharge into transistors T$_2$ and T'$_1$, until the potential difference at its terminal equals the difference in threshold voltages of transistors T'$_2$ and T'$_1$, and then to make the output transistors (I$_2$, I'$_2$) conducting when this difference in threshold voltages is reached, this voltage being available between the sources of these output transistors (I$_2$, I'$_2$) whose drains are connected to the terminals of the capacitor (C'), the drains of the transistors T'$_2$ and T'$_1$ being respectively connected to the drain of the charge and discharge transistors (I$_3$, I'$_3$) whose sources are connected to the said d. c. voltage source (V'$_1$).

3. Reference voltage generator according to Claim 2, characterized in that the source of one of the output transistors (I'$_2$) is connected to means of taking this source to a predetermined bias potential (V$_0$) with respect to the potential of the substrate of the transistors T'$_2$ and T'$_1$.

4. Reference voltage generator according to Claim 3, characterized in that the length L$_1$ of the channel T'$_1$ is greater than 30 μ and that the length L$_2$ or the width Z$_2$ of the channel of T'$_2$ is less thant 5 μ.

5. Reference voltage generator according to Claim 4, characterized in that the capacitor (C') and the MOS transistors are produced in the form of an integrated circuit on a substrate.

## Patentansprüche

1. Bezugsspannungsgenerator mit zwei Transistoren T'$_1$ und T'$_2$ vom Typ MOS, die auf dem gleichen Substrat hergestellt sind, dadurch gekennzeichnet, daß die Kanäle dieser Transistoren die Längen L$_1$ bzw. L$_2$ und die Breiten Z$_1$ bzw. Z$_2$ aufweisen, daß einer der Transistoren T'$_2$ einen Kanal aufweist, dessen eine Abmessung und eine Stufe von der gleichen Größenordnung wie die entsprechende Abmessung der Ausdehnung des Raumladungsbereiches, der um diese Source und diese Drain beim Betrieb des Transistors auftritt, in Bezug auf die Source (S'$_2$) und die Drain (D'$_2$) ist, wobei die andere Abmessung in Bezug auf die entsprechende Abmessung der genannten Ausdehnung des Raumladungsbereiches groß ist, daß der andere Transistor T'$_1$ einen Kanal aufweist, dessen beide Abmessungen gegenüber der Abmessung der Ausdehnung des entsprechenden Raumladungsbereiches groß sind, und daß der Bezugsspannungsgenerator umfaßt Mittel, um die gemeinsame Source-Substrat-Spannung (VBS) der Transistoren $T'_1$ und $T'_2$ festzulegen, deren Source ($S_2$, $S'_2$) an einem gemeinsamen Punkt (S) vereinigt sind, Mittel, um den Unterschied der Schwellenspannungen der Transistoren $T'_1$ und $T'_2$ durch Messen des Unterschiedes der Gate-Source-Spannung der jeweiligen Transistoren $T'_1$ und $T'_2$ zu erhalten, wobei diese Mittel einen Kondensator (C'), dessen beide Klemmen über zwei Steuerschalter ($I_3$, $I'_3$) zum Aufladen und Entladen mit einem ersten Punkt (D'), den das Gate ($T'_2$) und die Drain ($D'_2$) des Transistors $T'_2$ gemeinsam haben, und einem zweiten Punkt (D") verbunden sind, den das Gate ($T'_1$) und die Drain ($D'_1$) des Transistors $T'_1$ gemeinsam haben, daß der erste und zweite gemeinsame Punkt (D', D") mit einer Gleichspannungsquelle ($V'_1$) über zwei Schalter ($I'_1$ und $I''_1$) zum Anlegen einer Spannung derart verbunden sind, daß, wenn die beiden Schalter ($I_3$, $I'_3$) zum Aufladen und Entladen und die beiden Schalter ($I'_1$ und $I''_1$) zum Anlegen einer Spannung geschlossen sind, sich jeder der Belege des Kondensators (C') auf das Potential der Quelle ($V'_1$) auflädt, und daß, wenn die Schalter ($I'_1$ und $I''_1$) zum Anlegen einer Spannung geöffnet und die Schalter ($I_3$, $I'_3$) zum Steuern des Aufladens und des Entladens geschlossen sind, sich die Belege des Kondensators in die Transistoren $T'_2$ und $T'_1$ entladen, bis der an den Klemmen dieses Kondensators (C') bereitgestellte Potentialunterschied gleich dem Unterschied der Schwellenspannungen der Transistoren $T'_1$ und $T'_2$ ist, daß der Unterschied der Schwellenspannungen der Transistoren $T'_2$ und $T'_1$ an den Klemmen des Kondensators (C') über zwei Ausgangsschalter ($I_2$, $I'_2$) zur Verfügung steht, die nach dem Öffnen der Steuerschalter ($I_3$, $I'_3$) für das Aufladen und Entladen geschlossen sind, wenn der Potentialunterschied an den Klemmen des Kondensators (C') gleich dem Unterschied der Schwellenspannungen der Transistoren $T'_2$ und $T'_1$ ist.

2. Bezugsspannungsgenerator nach Anspruch 1, dadurch gekennzeichnet, daß die Schalter ($I_3$, $I'_3$) zum Aufladen und Entladen, die Schalter ($I'_1$, $I''_2$) zum Anlegen einer Spannung und die Ausgangsschalter ($I_2$ und $I'_2$) MOS-Transistoren sind, deren Gate mit den Steuermitteln ($\phi_3$) verbunden sind, um die Steuertransistoren ($I_3$ und $I'_3$) zum Aufladen und Entladen und die Transistoren ($I'_1$, $I''_1$) zum Anlegen einer Spannung während einer Zeitdauer leitfähig zu machen, die ausreicht, um die Belege des Kondensators (C') auf das Potential der Quelle ($V'_1$) aufzuladen, um dann die Transistoren ($I'_1$, $I''_1$) zum Anlegen einer Spannung zu unterbrechen, damit sich die Belege des Kondensators (C') in die Transistoren $T'_2$ und $T'_1$ entladen, bis der Potentialunterschied an seinen Klemmen gleich dem Unterschied der Schwellenspannungen der Transistoren $T'_2$ und $T'_1$ ist, um dann die Ausgangstransistoren ($I_2$, $I'_2$) leitend zu machen, wenn dieser Unterschied der Schwellenspannungen erreicht ist, daß diese Spannung zwischen den Source dieser Ausgangstransistoren ($I_2$, $I'_2$) vorliegt, deren Drains mit den Klemmen des Kondensators (C') verbunden sind, und daß die Drains der Transistoren $T'_2$ und $T'_1$ mit den entsprechenden Drains der Transistoren ($I_3$, $I'_3$) zum Aufladen und Entladen verbunden sind, deren Source mit der Gleichspannungsquelle ($V'_1$) verbunden sind.

3. Bezugsspannungsgenerator nach Anspruch 2, dadurch gekennzeichnet, daß die Source von einem der Ausgangstransistoren ($I'_2$) mit Mitteln verbunden ist, um diese Source auf ein vorbestimmtes Polarisationspotential ($V_0$) in Bezug auf das Potential des Substrats der Transistoren $T'_2$ und $T'_1$ zu bringen.

4. Bezugsspannungsgenerator nach Anspruch 3, dadurch gekennzeichnet, daß die Länge ($L_1$) des Kanals $T'_1$ größer als 30 μm und die Länge ($L_2$) oder die Breite ($Z_2$) des Kanals von $T'_2$ kleiner als 5 μm ist.

5. Bezugsspannungsgenerator nach Anspruch 4, dadurch gekennzeichnet, daß der Kondensator (C') und die MOS-Transistoren in der Form eines integrierten Schaltkreises auf einem Substrat hergestellt sind.

FIG. 1

FIG. 2a

FIG. 2b

$\Delta Vt = Vt_2 - Vt_1$

1,5V

$-2\phi F$

$V_{BS}$

10V

$a \quad Z_2 = 1\mu$

$b \quad Z_2 = 2\mu$

$c \quad Z_2 = 10\mu$

$d \quad L_3 = 10\mu$

$e \quad L_3 = 2\mu$

$f \quad L_3 = 1\mu$

$\Delta Vt = Vt_3 - Vt_1$

FIG. 3

$I_1 \quad V_1$

$\phi_1$

1

2

3

$A$

$G_2 \quad D_2$

$T_2 \quad S_2$

$C$

$E$

$V_{BS_2}$

$B$

FIG. 4 a

$\phi_1$ ⓐ

$\Delta t$ $t$

$V_D - V_S$ ⓑ

$V_1$

$V_T$ $t$

FIG. 4 b

FIG. 5